(19) **Europäisches Patentamt**

**European Patent Office**

**Office européen des brevets**

(11) Veröffentlichungsnummer: **0 439 657 A1**

## (12) EUROPÄISCHE PATENTANMELDUNG

(21) Anmeldenummer: **90101937.2**

(22) Anmeldetag: **31.01.90**

(51) Int. Cl.⁵: **G01R 23/17**

(43) Veröffentlichungstag der Anmeldung:
**07.08.91 Patentblatt 91/32**

(84) Benannte Vertragsstaaten:
**FR GB IT**

(71) Anmelder: **Siemens Aktiengesellschaft**
**Wittelsbacherplatz 2**
**W-8000 München 2(DE)**

(72) Erfinder: **Zensen, Wilfried, Dr.**
**Wessobrunner Strasse 2**
**W-8035 Gauting(DE)**
Erfinder: **Storck, Eckhard, Dr.**
**Argelsrieder Strasse 27**
**W-8000 München 71(DE)**
Erfinder: **Stockmann, Michael, Dipl.-Phys.**
**Enzianweg 18**
**W-8206 Götting(DE)**

(54) **Interferometrischer Braggzellen-Spektralanalysator.**

(57)

2.1. Es wird ein Braggzellen-Spektralanalysator angegeben, bei dem eine Störaustastung möglich ist, welche die Qualität der Spektralanalyse nicht beeinflußt.

2.2. Dazu weist der Analysator eine auf das Referenzsignal (R) einwirkende Einrichtung (RE) zum wahlweisen und zeitweiligen Verschwindenbringen einer oder mehrerer Frequenzen ($f_u$ bis $f_o$) des Referenzfrequenzspektrums (RS) auf.

2.3. Interferometrische Braggzellen-Spektralanalysatoren

EP 0 439 657 A1

## INTERFEROMETRISCHER BRAGGZELLEN-SPEKTRALANALYSATOR

Die Erfindung betrifft einen interferometrischen Braggzellen-Spektralanalysator nach dem Oberbegriff des Patentanspruchs 1.

Analysatoren der genannten Art sind bekannt und hinsichtlich ihres Aufbaus und ihrer Funktionsweise beispielsweise in Appl. Optics, Vol. 20, No. 16, 15. Nov. 1981, Seiten 2770-2279, in Appl. Optics, Vol. 23, No. 23, 1. Dez. 1984, Seiten 4269-4279 oder auch in SPIE, Vol. 639, Optical Information Processing II (1986), Seiten 126-130 näher beschrieben.

Derartige Analysatoren gehören wie elektronische Filterbänke zur Gruppe der kanalisierenden Spektrometer. Die Kanäle kann man sich als Bandpaßfilter vorstellen, die jeweils über eine vorbestimmte Bandbreite $f_j$-$f_i$ messen. Da die Filtercharakteristik dieser Kanäle aus verschiedenen Gründen nicht rechteckförmig ist, werden abgeschwächt auch Frequenzen unterhalb der unteren Frequenz $f_i$ und oberhalb der oberen Frequenz $f_j$ der Bandbreite $f_j$-$f_i$ durchgelassen. Bei den optisch arbeitenden Spektralanalysatoren, zu denen der interferometrische Braggzellen-Spektralanalysator gehört, trifft man häufig eine gaußkurvenförmige Filtercharakteristik der Kanäle an.

Bietet man einem kanalisierenden Spektralanalysator eingangsseitig eine einem bestimmten Kanal zugeordnete Frequenzlinie ausreichend starker Intensität an, zeigt das Gerät Intensität von dieser Frequenzlinie her nicht nur im zugeordneten Kanal, sondern auch in Nachbarkanälen. Eine einem solchen Nachbarkanal zugeordnete eingangsseitige angebotene Frequenzlinie vergleichsweise schwacher Intensität kann in diesem Kanal je nach dem Verhältnis zwischen der starken und schwachen Intensität ausgangsseitig völlig von den Ausläufern der störenden starken Intensität überdeckt sein.

Zur Ausschaltung störender Intensitäten in einem Spektralanalysator sind sogenannte "Exciser" vorgeschlagen worden (siehe John N. Lee et al: High Speed Adaptive Filtering and Reconstruction of Broad-Band Signals Using A Acousto-Optic Techniques, 1980, Ultrasonics Symposium IEEE, pp. 488), die als "Vorschaltgerät" für den Spektralanalysator eingesetzt werden können. Die Störunterdrükkung mit einem solchen Exciser funktioniert gut, jedoch wird die Qualität der Spektralanalyse beeinflußt.

Aufgabe der Erfindung ist es, einen interferometrischen Braggzellen-Spektralanalysator der eingangs genannten Art anzugeben, bei dem eine Störaustastung möglich ist, welche die Qualität der Spektralanalyse nicht beeinflußt.

Diese Aufgabe wird durch die im kennzeichnenden Teil des Patentanspruchs 1 angegebenen Merkmale gelöst.

Bei dem erfindungsgemäßen Analysator werden zur Austastung störender Signale die speziellen Eigenschaften des zugrundeliegenden Überlagerungsprinzips ausgenutzt.

Eine mit relativ geringem baulichem Aufwand realisierbare vorteilhafte Ausgestaltung des erfindungsgemäßen Analysators ist im Anspruch 2 angegeben.

Bevorzugte und vorteilhafte Ausgestaltungen des Analysators nach Anspruch 2 gehen aus den Ansprüchen 3 bis 6 hervor. Die in den Ansprüchen 4 und 5 definierten Ausführungen der Referenzsignalquelle sind in den Patentanmeldungen P 38 26 882.5 (= GR 88 P 1485 DE) und P 38 26 881.7 (= GR 88 P 1486DE ) mit dem gleichen Anmeldetag ausführlich beschrieben.

Die Erfindung wird in der folgenden Beschreibung anhand der Zeichnungen beispielhaft näher erläutert. Von den Figuren zeigen:

Figur 1     schematisch die wesentlichen Teile des erfindungsgemäßen Spektralanalysators,

Figur 2     ein dem Analysator angebotenes spezielles Eingangsspektrum,

Figur 3     eine Analysatorantwort auf das spezielle Eingangsspektrum bei vorhandenen Frequenzen des Referenzfrequenzspektrums vor einer Zwischenfrequenzfilterung und darunter die Antwort nach dieser Filterung,

Figur 4     eine Analysatorantwort auf das spezielle Eingangsspektrum bei Ausschaltung der Frequenz $S_{Rb}$ des Referenzfrequenzspektrums vor der Zwischenfrequenzfilterung und darunter die Antwort nach der Filterung, und

Figur 5     schematisch eine Ausführungsform der Einrichtung zum Verschwindenbringen einer oder mehrerer Frequenzen des Referenzspektrums zusammen mit der Referenzsignalquelle zum Erzeugen dieses Referenzspektrums.

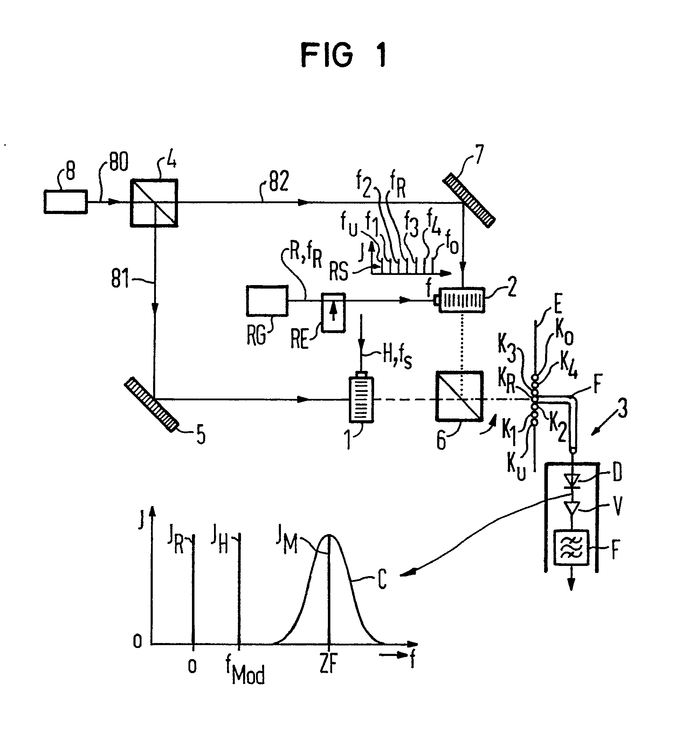

Der in Figur 1 dargestellte interferometrische Spektralanalysator besteht im wesentlichen aus der Signal-Braggzelle 1, der Referenz-Braggzelle 2 und dem mehrkanaligen optischen Heterodynempfänger 3. Beiden Braggzellen 1 und 2 wird aus einer gemeinsamen Laserquelle 8 Laserlicht zugeleitet, das nach Durchgang durch die Zellen 1 und 2 überlagert dem Empfänger 3 zugeleitet ist.

Beispielsweise wird dazu ein von der Laserquelle 8 ausgesandter Laserstrahl 80 durch einen Strahlteiler 4 in zwei Teilstrahlen 81 und 82 zerlegt. Ein Teilstrahl 81 wird über einen Umlenkspiegel der Signal-Braggzelle 1 und der andere Teilstrahl 82 über einen Umlenkspiegel 7 der Referenz-Braggzelle 2 zugeleitet.

Der Signal-Braggzelle 1 wird ein zu analysierendes Hochfrequenzsignal H und der Referenz-Braggzelle 2 ein Referenzsignal R als Steuersignal zugeleitet. Das Referenzsignal R weist ein aus einer Vielzahl von Frequenzlinien bestehendes und die vorbestimmte Bandbreite des Analysators umfassendes Referenzfrequenzspektrum RS auf, dessen Frequenzlinien über einer Frequenzachse f als Intensität I dargestellt sind und der Reihe nach zunehmenden Frequenzen $f_u$, $f_1$, $f_2$, $f_R$, $f_3$, $f_4$ und $f_o$ entsprechen. Das dargestellte Referenzfrequenzspektrum RS dient nur zur Illustration und steht stellvertretend für ein Referenzfrequenzspektrum der Praxis, das 100 und mehr Frequenzlinien mit vorzugsweise gleicher Intensität aufweisen kann.

Die Trägerfrequenz $f_R$ von beispielsweise 2040 MHz des Referenzfrequenzspektrums RS und damit das ganze Spektrum selbst ist gegenüber der Trägerfrequenz $f_s$ von beispielsweise 2000 MHz des Hochfrequenzsignals H um einen festen Frequenzbetrag $|f_R-f_s|$ verschoben, der eine Heterodyn-Zwischenfrequenz ZF bildet.

Der in der Signal-Braggzelle 1 entsprechend der Frequenz $f_s$ abgelenkte Teilstrahl 81, dessen Frequenz um diese Frequenz verschoben ist, und der in der Referenz-Braggzelle 2 entsprechend der Frequenz $f_R$ abgelenkte Teilstrahl, dessen Frequenz um diese Frequenz $f_R$ verschoben ist, werden durch einen Strahlteiler 6 überlagert und durch eine nicht dargestellte Abbildungsoptik in einer Ebene E fokussiert, in der ein Feld aus nebeneinander angeordneten Detektorfenstern $K_u$, $K_1$, $K_2$, $K_R$, $K_3$, $K_4$ und $K_o$ des mehrkanaligen Heterodynempfängers 3 angeordnet sind.

Jedes dieser Detektorfenster $K_u$ bis $K_o$ repräsentiert einen Kanal des Analysators, einer Frequenz $f_u$ bis $f_o$ des Referenzfrequenzspektrums RS umkehrbar eindeutig zugeordnet ist.

Die Detektorfenster $K_u$ bis $K_o$ können beispielsweise in der Ebene E angeordnete Enden von Lichtleitfasern F oder anderen Lichtwellenleitern sein, von denen jede bzw. jeder zu einem zugeordneten optoelektrischen Detektor D führt, dessen Ausgangssignal beispielsweise in einem Verstärker V verstärkt einem Bandpaßfilter BF mit Zwischenfrequenz $|f_R-f_s|$ als Mittenfrequenz zugeleitet wird. In der Figur 1 ist diese Anordnung aus Faser F, Detektor D, Verstärker V und Filter BF der Einfachheit halber nur für das Detektorfenster $K_R$ dargestellt, es ist jedoch für jedes andere Detektorfenster eine solche Anordnung vorgesehen.

Das Referenzfrequenzspektrum RS und die Abmessungen der Detektorfenster $K_u$ bis $K_o$ sind so aufeinander abgestimmt, daß jedes dieser Fenster $K_u$ bis $K_o$ mit einer zugeordneten Signalfrequenz und einer zugeordneten Referenzfrequenz versorgt wird, die sich um die feste Zwischenfrequenz ZF voneinander unterscheiden. Damit haben in dem Beispiel nach Figur 1 alle Kanäle des Analysators die gleiche Zwischenfrequenz ZF.

Geht man ohne Beschränkung der Allgemeinheit von dem Detektorfenster $K_R$, das mit dem zugeordneten Frequenzpaar $f_s$, $f_R$ versorgt wird, aus - jedes andere Detektorfenster und das zugeordnete Frequenzpaar können als Ausgangspunkt dienen - so wird das eine benachbarte Detektorfenster $K_2$ mit dem Frequenzpaar $f_s$-$\Delta f$, $f_2 = f_R$- $\Delta f$ und das andere Detektorfenster $K_3$ mit dem Frequenzpaar $f_s$ + $\Delta f$, $f_3 = f_R$ + $\Delta f$ versorgt, wobei $\Delta f$ den Abstand zwischen $f_R$ und $f_2$ bzw. $f_R$ und $f_2$ bedeutet und beispielsweise 10 MHz beträgt. Bei äquidistanten Frequenzlinien des Referenzfrequenzspektrums RS ist dem vom Detektorfenster $K_R$ in Richtung des Detektorfensters $K_u$ gezählten n-ten Detektorfenster das Frequenzpaar $f_s$-n·$\Delta f$, $f_R$-n·$\Delta f$ zugeordnet. Auf der anderen Seite des Detektorfensters $K_R$ ist dem n-ten Detektorfenster das Frequenzpaar $f_s$+n·$\Delta f$, $f_R$+n·$\Delta f$ zugeordnet. n bedeutet dabei eine natürliche Zahl von 1 bis mindestens u und o.

Das Ausgangssignal eines Kanals im interferometrischen Spektralanalysator entsteht durch Amplitudenmultiplikation des zugeführten Signal- und Referenzlichts im Empfangsbereich des betreffenden Kanals. Das resultierende Ausgangssignal des Detektors D eines Kanals besteht generell aus einem vom Referenzsignal R stammenden Gleichspannungsanteil einer bestimmten Intensität $I_R$, einem vom Hochfrequenzsignal H stammenden, relativ niederfrequenten Anteil einer bestimmten Intensität $I_H$ und einer bestimmten Frequenz $f_{Mod}$ und aus einem Mischprodukt zwischen der Amplitude der diesem Kanal zugeordneten Signalfrequenz und der Amplitude der diesem Kanal zugeordneten Referenzfrequenz bei der Zwischenfrequenz ZF. In dem in der Figur 1 eingezeichneten Diagramm, bei welcher die Intensität I über der Frequenz f aufgetragen ist, sind diese Intensitäten und zugehörigen Frequenzen für den dem Detektorfenster $K_R$ zugeordneten Kanal und stellvertretend für die übrigen Kanäle des Analysators dargestellt. Die Intensität des Mischprodukts bei der Zwischenfrequenz ZF ist dort mit $I_M$ bezeichnet. Die Kurve C in dem Diagramm repräsentiert die Filtercharakteristik des Bandpaßfilters BF mit der Mittenfrequenz ZF.

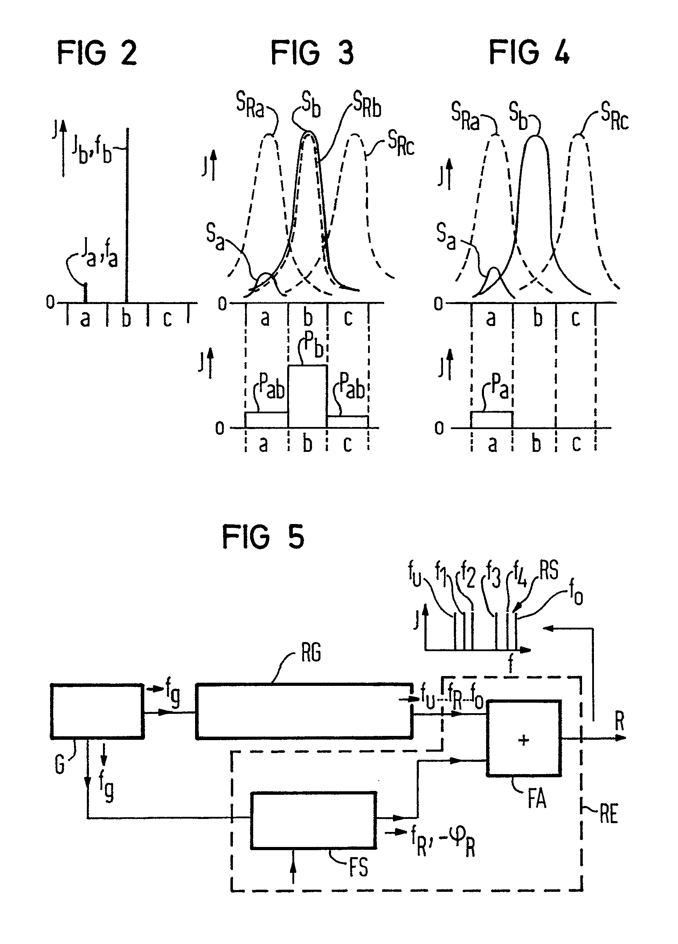

Unter Bezugnahme auf die Figuren 2 bis 4 seien drei beliebige benachbarte Kanäle a, b und c des Analysators betrachtet, denen drei benachbarte Detektorfenster nach Figur 1 zugeordnet sind, welche nicht näher bezeichnet sind, da jedes Tripel benachbarter Fenster in Frage kommt.

Es sei angenommen, das der Signal-Braggzelle 1 zugeführte Hochfrequenzsignal H enthalte eine Signalfrequenz relativ schwacher Intensität, die einem bestimmten Kanal zugeordnet ist und eine, einem Nachbarkanal zugeordnete Signalfrequenz relativ starker Intensität. Ohne Beschränkung der Allgemeinheit sei für das folgende das beispielhafte Eingangsspektrum nach Figur 2 angenommen, bei welchem die dem Kanal a zugeordnete Signalfrequenz $f_a$ von relativ schwacher Intensität $I_a$ und die dem Nachbarkanal b zugeordnete Signalfrequenz $f_b$ von relativ starker Intensität $I_b$ sei.

Die Kurven $S_a$ und $S_b$ in den Figuren 3 und 4 geben die Antwort des Braggzellen-Spektralanalysators auf das Eingangsspektrum nach Figur 2 in der Ebene E in Figur 1 im Bereich der dortigen Detektorfenster wieder. Danach ist das der Signalfrequenz $f_a$ der schwachen Intensität $I_a$ sowie dem Kanal a zugeordnete Intensitätssignal $S_a$ relativ schwach und reicht nicht wesentlich in den Nachbarkanal b hinüber, während das der Signalfrequenz $f_b$ der starken Intensität $I_b$ sowie dem Kanal b zugeordnete Intensitätssignal $S_b$ relativ stark ist und mit einer Intensität in die Nachbarkanäle a und c hineinragt, die mit der Intensität des Signals $S_a$ vergleichbar ist. In jedem Kanal a, b und c ist auch das zugeordnete Referenz-Intensitätssignal $S_{Ra}$, $S_{Rb}$ bzw. $S_{Rc}$ vorhanden. Diese Referenz-Intensitätssignale werden durch die den benachbarten Kanälen a, b und c zugeordneten und voneinander verschiedenen Referenzfrequenzen des Referenzfrequenzspektrums erzeugt, die der Referenz-Braggzelle zugeführt sind und die hier mit $f_{Ra}$, $f_{Rb}$ bzw. $f_{Rc}$ bezeichnet seien.

Die Amplitude sämtlicher Referenz-Intensitätssignale ist beispielsweise gleich und relativ groß, z.B. gleich der Amplitude des Intensitätssignals $S_b$. Jedes Referenz-Intensitätssignal $S_{Ra}$, $S_{Rb}$, $S_{Rc}$ ragt mit einer relativ großen Intensität in die Nachbarkanäle, beispielsweise mit etwa der Intensität, mit welcher das Intensitätssignal $S_b$ in die Nachbarkanäle hineinragt.

Im Kanal a sind die Signale $S_{Ra}$ und $S_a$ überlagert. Da sich die zugeordneten Frequenzen $f_a$ und $f_{Ra}$ um die Zwischenfrequenz ZF unterscheiden, erzeugen sie ein Zwischenfrequenzsignal, das vom Bandpaßfilter BF dieses Kanals a durchgelassen wird.

Im Kanal a sind auch das Intensitätssignal $S_b$ und das Referenz-Intensitätssignal $S_{Rb}$ überlagert, deren zugeordnete Frequenzen $f_b$ und $f_{Rb}$ sich um die Zwischenfrequenz ZF unterscheiden und die damit ein Zwischenfrequenzsignal erzeugen, das vom Bandpaßfilter BF des Kanals a ebenfalls durchgelassen wird. Die übrigen Zwischenfrequenzen $|f_a\text{-}f_{Rb}|$, $|f_a\text{-}f_b|$ und $|f_b\text{-}f_{Ra}|$ sind von ZF verschieden und werden daher von dem Filter D des Kanals a nicht durchgelassen.

Demnach wird am Ausgang des Filters BF des Kanals a ein Signal $P_{ab}$ erhalten, in dem Signale aus verschiedenen Kanälen, dem Kanal a und dem Kanal b, überlagert sind.

Im Kanal b ist das zugeordnete Intensitätssignal $S_b$ mit dem zugeordneten Referenz-Intensitätssignal $S_{Rb}$ und überdies mit den Ausläufern der Referenz-Intensitätssignale $S_{Ra}$ und $S_{Rc}$ der Nachbarkanäle überlagert. Danach sind in diesen Signalen die Zwischenfrequenz ZF = $|f_b\text{-}f_{Rb}|$ und die von dieser Zwischenfrequenz verschiedenen Zwischenfrequenzen $|f_b\text{-}f_{Ra}|$, $|f_b\text{-}f_{Rc}|$, $|f_{Ra}\text{-}f_{Rb}|$, $|f_{Ra}\text{-}f_{Rc}|$ und $|f_{Rb}\text{-}f_{Rc}|$ enthalten. Dementsprechend erzeugen nur die Signale $S_b$ und $S_{Rb}$ ein Zwischenfrequenzsignal, das durch das Filter BF dieses Kanals b paßt, am Ausgang dieses Filters BF als Signal $P_b$ entnehmbar ist und keine Signale aus den Nachbarkanälen a und c enthält.

Im Kanal c sind dem zugeordneten Referenz-Intensitätssignal $S_{Rc}$ die Ausläufer des Intensitätssignals $S_b$ und des Referenz-Intensitätssignals $S_{Rb}$ des Nachbarkanals b überlagert. In diesen Signalen sind die Zwischenfrequenz ZF = $|f_b\text{-}f_{Rb}|$ und die davon verschiedenen Zwischenfrequenzen $|f_b\text{-}f_{Rc}|$ und $|f_{Rb}\text{-}f_{Rc}|$ enthalten. Demnach erzeugen nur die Signale $S_b$ und $S_{Rb}$ des Nachbarkanals b im Kanal c ein Zwischenfrequenzsignal, das durch das Bandpaßfilter BF dieses Kanals c paßt und am Ausgang dieses Filters als Signal $P_{ob}$ erscheint, obwohl diesem Kanal c keine zugeordnete Signalintensität zugeführt ist.

Nach dem vorstehend Dargelegten wird nur im Kanal b ein richtiges Signal gemessen, während in den Kanälen a und c nur verfälschte Signale oder Scheinsignale gemessen werden.

Es wurde erkannt, daß unter den gegebenen Verhältnissen auch in den Kanälen a und c die unverfälschten Zustände gemessen werden können, wenn es gelingt, das Referenz-Intensitätssignal $S_{Rb}$ des Kanals b zeitweilig zum Verschwinden zu bringen, wie es in der Figur 4 dargestellt ist. In dieser Zeit gibt es in den Kanälen a und c keine von den Ausläufern der Signale $S_b$ und $S_{Rb}$ erzeugte Zwischenfrequenz ZF, die durch das Filter BF des betreffenden Kanals a bzw. c paßt. Im Kanal a erzeugen nur die diesem

Kanal zugeordneten Signale $S_a$ und $S_{Ra}$ ein Zwischenfrequenzsignal mit der richtigen Zwischenfrequenz ZF, das durch das Filter BF dieses Kanals a paßt und am Ausgang dieses Filters als Signal $P_a$ verfügbar ist. Auch der richtige Zustand des Kanals c kann festgestellt werden, d.h. es wird in diesem Kanal c kein Ausgangssignal gemessen, weil das Hochfrequenzsignal H keine dem Kanal c zugeordnete Signalfrequenz enthält.

Während der Zeit, in der das Referenz-Intensitätssignal $S_{Rb}$ des Kanals b zum Verschwinden gebracht ist, kann im Kanal b nicht der richtige Zustand gemessen werden.

Nach dem vorstehend Dargelegten kann also durch zeitweiliges zum Verschwindenbringen eines bestimmten Referenz-Intensitätssignals der Spektral-Analysator trotz eines starken Störsignals in einem Kanal ein schwaches Intensitätssignal im Nachbarkanal ohne Fehler oder Dynamikverlust messen.

Das einem Kanal zugeordnete Referenz-Intensitätssignal kann dadurch zum Verschwinden gebracht werden, daß die dieses Signal erzeugende Referenzfrequenz im Referenzfrequenzspektrum zum Verschwinden gebracht wird.

Die meisten Hochfrequenz-Referenzfrequenzquellen erzeugen ihr Referenzfrequenzspektrum durch einen nichtlinearen Prozeß oder eine Chirp-Erzeugung. Eine Abschaltung einer oder mehrerer Referenzlinien durch Eingriff in den Erzeugungsvorgang ist nahezu unmöglich.

Die Erfindung weist den Weg, eine Referenzlinie eines Referenzfrequenzspektrums durch Einwirkung auf das bereits erzeugte Referenzsignal zum Verschwinden zu bringen. Demgemäß weist der Braggzellen-Spektralanalysator nach Figur 1 eine auf das von der Referenzsignalquelle RG erzeugte und der Referenz-Braggzelle 2 zugeführte Referenzsignal R einwirkende Einrichtung RE zum wahlweisen und zeitweiligen Verschwindenbringen einer oder mehrerer Frequenzen des Referenzfrequenzspektrums RS auf.

Bei einer zweckmäßigen Realisierung dieses Konzepts ist eine Referenzsignalquelle RG vorgesehen, die ein Referenzspektrum RS aus Frequenzen $f_u$ bis $f_o$ mit zu jedem Zeitpunkt definierten Frequenz- und Phasenwerten erzeugt, vorzugsweise zeitlich konstante äquidistante Frequenzlinien gleicher Intensität, die phasenstarr zu einer definierten Grund- oder Basisfrequenz $f_g$ erzeugt werden.

Geeignet dafür ist die bereits angemeldete Anordnung aus einem von der definierten Grundfrequenz $f_g$ angesteuerten Kammgenerator und einer Dem Kammgenerator nachgeschalteten Filter- und Impulsverteilungseinrichtung, der das Referenzsignal R mit den definierten Frequenzen entnehmbar ist.

Auch die bereits angemeldete und von der definierten Grund-oder Basisfrequenz $f_g$ und daraus abgeleiteten definierten Frequenzen angesteuerte Mischerkette, der das Referenzsignal entnehmbar ist, kann verwendet werden.

Prinzipiell ist jedoch jede Referenzsignalquelle RG geeignet, deren Referenzspektrum die gewünschten Eigenschaften aufweist.

Unter diesen Voraussetzungen kann die Einrichtung RE zum Verschwindenbringen einer oder mehrerer Frequenzen des Referenzfrequenzspektrums RS einen Generator FS zum wahlweisen und zeitweiligen gegenphasigen Erzeugen einer oder mehrerer der definierten Frequenzen und einen Frequenzaddierer FA zum Addieren einer gegenphasig erzeugten Frequenz zum Referenzsignal R aufweisen.

Eine definierte Frequenz des Referenzfrequenzspektrums RS und die dazu gegenphasig erzeugte Frequenz löschen sich gegenseitig weitgehend aus, wenn ihre Amplituden weitgehend gleich sind. In der Figur 5, in der die Einrichtung RE detaillierter dargestellt ist, ist beispielsweise angenommen, daß die Frequenz $f_R$ zum Verschwinden gebracht werden soll. Unter den genannten Voraussetzungen ist die Frequenz $f_R$ und deren Phase $\phi_R$ zu jedem Zeitpunkt bekannt. Der Generator $F_S$ erzeugt diese definierte Frequenz $f_R$ mit der Phase $-\phi_R$. Im Addierer FA wird die zugeordnete Frequenzlinie ausgelöscht.

Der Generator FS zum wahlweisen und zeitweiligen gegenphasigen Erzeugen der definierten Frequenzen $f_u$ bis $f_o$ des Referenzfrequenzspektrums RS kann ein vorzugsweise von außen, z.B. mit gespeicherten Phasendaten, adressierbarer Synthesizer sein, der jede beliebige Referenzfrequenz aus der definierten Grund- oder Basisfrequenz $f_g$ abgeleitet wahlweise und zeitweilig erzeugt.

Bei der Ausführung nach Figur 5 ist angenommen, daß eine von einem Generator G
erzeugte Grundfrequenz f$_g$ sowohl die Referenzsignalquelle RG als auch den Generator
FS ansteuert. Sind dazu verschiedene Frequenzen zu verwenden, beispielsweise eine
Grundfrequenz und eine davon verschiedene
Basisfrequenz, so ist es zweckmäßig, eine dieser Frequenzen aus der anderen abzuleiten.

**Patentansprüche**

1. Interferometrischer Braggzellen-Spektralanalysator mit einer Signal-Braggzelle (1), einer
Referenz-Braggzelle (2) und einem mehrkanaligen optischen Heterodynempfänger (3), wobei
die Signal-Braggzelle (1) mit einem zu analysierenden Hochfrequenz-Signal (H) und die
Referenz-Braggzelle (2) mit einem Referenzsignal (R) mit einem Referenzfrequenzspektrum
(RS) ansteuerbar ist, das gegenüber einer
Hochfrequenz (f$_s$) des Hochfrequenzsignals um
einen festen Frequenzbetrag ($|f_s-f_r|$) verschoben
ist und die gesamte vorbestimmte Bandbreite
(f$_u$-f$_o$) des Analysators umfaßt,
**gekennzeichnet durch** eine auf das Referenzsignal (R) einwirkende Einrichtung (RE)
zum wahlweisen und zeitweiligen Verschwindenbringen einer oder mehrerer Frequenzen
(f$_u$ bis f$_o$) des Referenzfrequenzspektrums
(RS).

2. Analysator nach Anspruch 1, **dadurch gekennzeichnet**, daß eine Referenzsignalquelle
(RG) vorgesehen ist, die ein Referenzfrequenzspektrum (RS) aus Frequenzen (f$_u$ bis f$_o$) mit
zu jedem Zeitpunkt definierten Frequenz- und
Phasenwerten erzeugt, und daß die Einrichtung
(RE) zum Verschwindenbringen einer oder
mehrerer Frequenzen (f$_u$ bis f$_o$) des Referenzfrequenzspektrums (RS) einen Generator (FS)
zum wahlweisen und zeitweiligen gegenphasigen Erzeugen einer oder mehrerer der definierten Frequenzen (f$_u$ bis f$_o$) und einen Addierer (FA) zum Addieren einer gegenphasig erzeugten Frequenz zum Referenzsignal (R) aufweist.

3. Analysator nach Anspruch 2, **dadurch gekennzeichnet**, daß die Referenzsignalquelle
(RG) aus einer Einrichtung besteht, welche die
definierten Frequenzen (f$_u$ bis f$_o$) des Referenzspektrums (RS) phasenstarr zu einer definierten Grund- oder Basisfrequenz (f$_g$) erzeugt.

4. Analysator nach Anspruch 3, **dadurch gekennzeichnet**, daß die Referenzsignalquelle
(RG) einen von der definierten Grundfrequenz

(f$_g$) angesteuerten Kammgenerator und eine
dem Kammgenerator nachgeschaltete Filter-
und Impulsverteilungseinrichtung aufweist, der
das Referenzsignal (R) mit den definierten Frequenzen (f$_u$ bis f$_o$) entnehmbar ist.

5. Analysator nach Anspruch 3, **dadurch gekennzeichnet**, daß die Referenzsignalquelle
(RG) eine von der definierten Grund- oder Basisfrequenz (f$_g$) und daraus abgeleiteten definierten Frequenzen angesteuerte Mischerkette
aufweist, der das Referenzsignal entnehmbar
ist.

6. Analysator nach Anspruch 2 und einem der
Ansprüche 3 bis 5, **dadurch gekennzeichnet**,
daß der Generator (FS) zum wahlweisen und
zeitweiligen gegenphasigen Erzeugen einer
oder mehrerer der definierten Frequenzen (f$_u$
bis f$_o$) des Referenzfrequenzspektrums (RS)
aus einem Frequenzsynthesizer besteht, der
die eine oder mehrere gegenphasig zu erzeugenden Frequenzen (f$_u$ bis f$_o$) aus der definierten Grund- oder Basisfrequenz (f$_g$) abgeleitet
wahlweise und zeitweilig erzeugt.

# FIG 1

# FIG 2

# FIG 3

# FIG 4

# FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A,D | APPLIED OPTICS, Band 20, Nr. 6, 15. August 1981, Seiten 2770-2779, New York, US; A. VANDER LUGT: "Interferometric spectrum analyzer" * Seiten 2775-2777 * --- | 1 | G 01 R 23/17 |
| A,D | APPLIED OPTICS, Band 23, Nr. 23, 1. Dezember 1984, Seiten 4269-4279, New York, US; A. VANDERLUGT et al.: "Spatial and temporal spectra of periodic functions for spectrum analysis" * Seiten 4270-4272,4275-4276 * --- | 1 | |
| A | PROCEEDINGS OF SPIE, Band 639, OPTICAL INFORMATION PROCESSING (II), 1986, Seiten 131-139, Bellingham, WA, US; R. LU et al.: "Wideband interferometric acousto-optic spectrum analyzer" * Seite 132 * --- | 1 | |
| A | PROCEEDINGS OF THE SPIE, Band 639, OPTICAL INFORMATION PROCESSING II, 1986, Seiten 140-144, Bellingham, WA, US; E.H. YOUNG et al.: "Acousto-optic interferometric spectrum analyzer with direct RF frequency output" * Seite 141 * ----- | 1 | **RECHERCHIERTE SACHGEBIETE (Int. Cl.5)** G 01 R 23/17 . G 02 F 2/00 |

Der vorliegende Recherchenbericht wurde für alle Patentansprüche erstellt

| Recherchenort | Abschlußdatum der Recherche | Prüfer |
|---|---|---|
| DEN HAAG | 05-10-1990 | BOEHM CH.E.D. |